# EUROPEAN PATENT APPLICATION

(11) **EP 4 601 275 A1**
(43) Date of publication of application: **13.08.2025**
(21) Application number: 23890500.4
(22) Date of filing: 25.10.2023
(51) Int. Cl.: H04M 1/02, G06F 1/16

(54) **ROTATING MECHANISM AND FOLDABLE ELECTRONIC DEVICE**

(30) Priority: 15.11.2022 CN 202223033825 U
(71) Applicant: Honor Device Co., Ltd., Shenzhen, Guangdong 518040 (CN)
(72) Inventor: PENG, Gaofeng, Shenzhen, Guangdong 518040 (CN); DONG, Shaohong, Shenzhen, Guangdong 518040 (CN); CHEN, Ruihao, Shenzhen, Guangdong 518040 (CN); DAN, Jinqi, Shenzhen, Guangdong 518040 (CN)
(74) Representative: Gill Jennings & Every LLP
(86) International application number: PCT/CN2023/126439
(87) International publication number: WO 2024/104064

(57) **Abstract**

Embodiments of this application provide a rotation mechanism and a foldable electronic device. The rotation mechanism includes: a primary swing arm, a sliding bracket, a shaft cover, and a stop portion, where the primary swing arm includes a protruding portion disposed on a first end surface, the sliding bracket is of an integral structure and has a slideway that can accommodate the protruding portion and a sliding groove adapted to a sliding portion of the primary swing arm, the stop portion is disposed on one of the shaft cover and the sliding groove bracket, and when the primary swing arm rotates from an unfolded position to a closed position, the protruding portion is fitted with the stop portion, to prevent the primary swing arm from being disengaged from the sliding groove. The sliding groove bracket of the entire rotation mechanism is of an integral structure with a small quantity of parts, and the primary swing arm provided with the protruding portion can be ensured to be disposed in the sliding groove bracket of the integral structure.

## Description

This application claims priority to Chinese Patent Application No. 202223033825.2, filed with the China National Intellectual Property Administration on November 15, 2022 and entitled "ROTATION MECHANISM AND FOLDABLE ELECTRONIC DEVICE", which is incorporated herein by reference in its entirety.

### TECHNICAL FIELD

This application relates to the field of foldable screen terminal technologies, and in particular, to a rotation mechanism and a foldable electronic device.

### BACKGROUND

A foldable electronic device, for example, a foldable screen mobile phone, may have a flexible foldable display screen attached to a body in an inwardly or outwardly folding manner, to provide a large display area for a user when the body is fully unfolded. The body mainly includes two frames, and the two frames may rotate around a rotation mechanism. The rotation mechanism includes a shaft cover, a sliding groove bracket and a primary swing arm that are disposed on the shaft cover, a sliding groove formed by the sliding groove bracket is slidably connected to sliding portions on two sides of one end of the corresponding primary swing arm, and the other end of the primary swing arm is connected to a frame on a corresponding side. The primary swing arm connected to the frames on two sides may slide back and forth in the corresponding sliding groove to implement opening and closing of the body.

To prevent the primary swing arm from being disengaged from the sliding groove in a closing process, in a related technology, a protruding portion is disposed on the sliding portion of the primary swing arm, and the protruding portion can slide along a limiting groove in the sliding groove bracket to a stop portion disposed on the sliding groove bracket when the primary swing arm is closed, to limit sliding of the primary swing arm. For ease of assembly, generally, the sliding groove bracket is of a disassembled structure, and mainly includes an upper bracket and a lower bracket. The upper bracket and the lower bracket are configured to form the sliding groove adapted to the sliding portion. During assembly of the rotation mechanism, the lower bracket may be first mounted on the shaft cover, and then the primary swing arm is mounted on the lower bracket. Specifically, the sliding portion is embedded into the sliding groove, the protruding portion is inserted into the limiting groove, and finally, the upper bracket is correspondingly soldered to a preset position of the lower bracket, to form the sliding groove adapted to the primary swing arm.

However, because the sliding groove bracket is of a disassembled structure with a large quantity of parts, an overall fit tolerance chain is long. In addition, because there is a tolerance in a soldering process, after the upper bracket is correspondingly soldered at the preset position of the lower bracket, a position of the upper bracket relative to the position of the lower bracket may exist a certain offset, resulting in an increase in a width of the sliding groove, so that a fit clearance between the sliding portion of the primary swing arm and the sliding groove is increased, the primary swing arm is prone to shaking during sliding, and user experience is affected.

### SUMMARY

Embodiments of this application provide a rotation mechanism and a foldable electronic device, to reduce or even avoid a tolerance of the rotation mechanism during assembly, further to improve or avoid a case in which a width of a sliding groove on a sliding groove bracket is large and a fit clearance between the sliding groove and a sliding portion on a primary swing arm is too large, thereby improving stability of the primary swing arm during sliding.

An embodiment of this application provides a rotation mechanism, including a primary swing arm, a sliding groove bracket, and a shaft cover. The primary swing arm includes a sliding portion and a protruding portion, the primary swing arm includes a first end and a second end that are oppositely arranged in a length direction, the second end is configured to be connected to a frame of an electronic device, the protruding portion is disposed on a first end surface of the two opposite ends of the primary swing arm in the length direction, and the sliding portion is disposed on a side surface opposite to the primary swing arm in a width direction. The sliding groove bracket has a sliding groove adapted to the sliding portion and a slideway configured to accommodate the protruding portion, the slideway is an arc-shaped groove, when the sliding portion slides back and forth in the sliding groove, the protruding portion slides along the slideway, and the sliding groove bracket is of an integral structure. The shaft cover is located on one side of the sliding groove bracket facing away from the primary swing arm, a stop portion is disposed on one of the shaft cover and the sliding groove bracket, the stop portion protrudes from an inner surface of the shaft cover facing the sliding groove bracket and is located at one end of the slideway close to an edge of the sliding groove bracket, and when the primary swing arm rotates from an unfolded position to a closed position, the protruding portion is fitted with the stop portion, to prevent the primary swing arm from being disengaged from one end of the sliding groove close to the edge of the sliding groove bracket.

According to the rotation mechanism provided in this embodiment of this application, the protruding portion is disposed on the first end surface of the two opposite ends of the primary swing arm in the length manner, the stop portion is disposed on one of the shaft cover and the sliding groove bracket, and the sliding groove bracket is of an integral structure and is provided with a slideway adapted to the protruding portion. The primary swing arm provided with the protruding portion can be ensured to be disposed in the sliding groove bracket of the integral structure, so that the protruding portion is fitted with the stop portion after the primary swing arm is closed, and it is ensured that the primary swing arm is not disengaged from an assembly structure of the sliding groove bracket and the shaft cover. In addition, a total quantity of parts is small. This is convenient to assembly, and a case in which a width of the sliding groove formed on the sliding groove bracket is increased due to an assembly problem can also be avoided, so that a fit clearance between the sliding groove and the primary swing arm is moderate, the primary swing arm is not easy to shake during sliding, and user experience is improved.

In a possible implementation, one side of the stop portion facing the slideway has a first end surface. When the primary swing arm rotates from the unfolded position to the closed position, the protruding portion abuts against the first end surface. In this way, the protruding portion and the stop portion are not easy to slide or offset at an abutted position, and abutment is more stable and secure.

In a possible implementation, the slideway includes a slideway inner bottom wall, an opening end and a slideway end wall that are oppositely arranged in a sliding direction of the protruding portion. The slideway inner bottom wall is located between the opening end and the slideway end wall, the protruding portion is configured to move along the slideway inner bottom wall when the sliding portion slides back and forth along the sliding groove, and the slideway end wall is configured as a first end surface of the stop portion. When the primary swing arm rotates from the unfolded position to the closed position, the protruding portion enters the slideway through the opening end, and when the primary swing arm rotates to the closed position, the protruding portion abuts against the slideway end wall. In this way, the slideway can be better adapted to a moving track of the protruding portion, and the protruding portion is stopped at the slideway end wall. This is simple and effective in structure and is easy for processing.

In a possible implementation, the protruding portion is integrally formed and disposed on the first end surface of the primary swing arm. In this way, the protruding portion is integrally formed with the primary swing arm. This is easy for processing and not easy to be disengaged, and reliability of the structure is high.

In a possible implementation, a recessed portion is formed in a direction in which the first end surface of the primary swing arm faces the second end, an accommodating groove is further provided at one end of the recessed portion close to the second end, the accommodating groove communicates with the recessed portion, the protruding portion is embedded in the accommodating groove, and one end of the protruding portion extends out of a surface of the recessed portion. In this way, the protruding portion is detachably connected to the primary swing arm, so that an assembly manner among the primary swing arm, the sliding groove bracket, and the shaft cover can be more flexible, and can also be better adapted to the sliding groove bracket of the integral structure.

In a possible implementation, the stop portion is disposed on the shaft cover. In this way, only after the shaft cover is assembled with the sliding groove bracket, the stop portion is fitted with the protruding portion of the primary swing arm to perform a function of preventing disengagement. The primary swing arm and the sliding groove bracket may be first assembled, and then are integrally assembled on the shaft cover. The overall structure is skillful, easy for processing and of low costs, and it is convenient to assemble the primary swing arm with the protruding portion.

In a possible implementation, the stop portion further includes a second end surface connected to the first end surface. When the primary swing arm rotates to the unfolded position, a first side surface of the primary swing arm facing the shaft cover abuts against the second end surface. In this way, after the primary swing arm rotates from the closed position to the unfolded position, the second end surface of the stop portion may further perform a limiting function on the primary swing arm, to prevent the primary swing arm from rotating excessively and damaging other parts.

In a possible implementation, the second end surface of the stop portion is perpendicular to the first end surface of the stop portion. In this way, the primary swing arm may be rotated 90 degrees between the closed position and the unfolded position. This better meets actual use requirements and experience of the user.

In a possible implementation, the slideway is disposed on a side surface of the sliding groove bracket facing the primary swing arm. In this way, the slideway does not protrude from a surface of the sliding groove bracket, so that a moving track of the primary swing arm is not affected, and the protruding portion may be more flexibly disposed on the primary swing arm.

In a possible implementation, a raised portion is formed on a side surface of the sliding groove bracket facing the primary swing arm, the raised portion is recessed inward to form the slideway, the slideway separates the raised portion into a first protrusion and two second protrusions, the two second protrusions are oppositely arranged on two sides of the first protrusion, and the first protrusion and the two second protrusions jointly define the slideway. The first protrusion is configured as the stop portion, and one side of the first protrusion facing the slideway is the slideway end wall. The recessed portion on the primary swing arm is configured to avoid the second protrusions when the protruding portion slides into the slideway. An avoidance hole is further formed on the primary swing arm, and the first protrusion is configured to pass through the avoidance hole when the primary swing arm is at the unfolded position. In this way, the stop portion is disposed on the sliding groove bracket. This facilitates standard processing of the shaft cover. In addition, arc surfaces of the second protrusions may be set to be long and adapted to a rotation track of a bottom surface of the recessed portion of the primary swing arm, so that a sliding fit area between the primary swing arm and the sliding groove bracket is increased when the primary swing arm rotates, smoother rotation of the primary swing arm is enabled, and better user experience is provided.

In a possible implementation, when the primary swing arm rotates to the unfolded position, a first side surface of the primary swing arm facing the shaft cover abuts against a top surface of the shaft cover facing away from the edge of the sliding groove bracket. In this way, even if the first protrusion is disposed, the unfolded position of the primary swing arm is not limited.

In a possible implementation, the protruding portion is disposed at a central position of the first end of the primary swing arm, the primary swing arm includes two sliding portions, and the two sliding portions are respectively disposed on two opposite sides of the first end in the width direction. In this way, a structure of the primary swing arm may be more symmetrical, so that force is more evenly distributed during rotation, thereby facilitating improvement of hand feel of a user.

According to another aspect, an embodiment of this application provides a foldable electronic device, including the rotation mechanism according to any one of the first aspect or the various implementations of the first aspect, and a first frame and a second frame that can rotate around the rotation mechanism, where the first frame and the second frame are respectively connected to a second end of a primary swing arm in the rotation mechanism.

According to the electronic device provided in this embodiment of this application, the sliding groove bracket of the rotation mechanism used is of an integral structure, a protruding portion is disposed on a first end surface of two opposite ends of the primary swing arm in a length manner, and a stop portion is disposed on one of a shaft cover and the sliding groove bracket. A total quantity of parts is small. This is convenient to assembly, and a case in which a width of a sliding groove formed on the sliding groove bracket is increased due to an assembly problem can also be avoided, so that a fit clearance between the sliding groove and the primary swing arm is moderate, the primary swing arm is not easy to shake during sliding, and user experience is improved.

### BRIEF DESCRIPTION OF DRAWINGS

FIG. 1A is a schematic diagram of a form of a mobile phone with an inward foldable screen according to an embodiment of this application;
FIG. 1B is a schematic diagram of a form of a mobile phone with an outward foldable screen according to an embodiment of this application;
FIG. 2 is a schematic diagram of a structure of a mobile phone with an inward foldable screen in an unfolded state;
FIG. 3 is a schematic diagram of a complete structure of a rotation mechanism;
FIG. 4 is a schematic diagram of a primary swing arm at a closed position in a conventional rotation mechanism;
FIG. 5 is a schematic diagram of a primary swing arm at an unfolded position in a conventional rotation mechanism;
FIG. 6 is a schematic diagram of a structure of a rotation mechanism when a primary swing arm is at a closed position according to an embodiment of this application;
FIG. 7 is a schematic diagram of a structure of a rotation mechanism when a primary swing arm is at an unfolded position according to an embodiment of this application;
FIG. 8 is a schematic diagram of a structure of a primary swing arm according to an embodiment of this application;
FIG. 9 is a schematic diagram of a structure of a sliding groove bracket and a stop portion according to an embodiment of this application;
FIG. 10 is a schematic diagram of a cross-section of a rotation mechanism formed by assembling the structures shown in FIG. 8 and FIG. 9 in a closed state;
FIG. 11 is a schematic diagram of a cross-section of the rotation mechanism shown in FIG. 10 in an unfolded state;
FIG. 12 is a schematic diagram of a structure of another primary swing arm according to an embodiment of this application;
FIG. 13 is a schematic diagram of a structure of another sliding groove bracket and another stop portion according to an embodiment of this application;
FIG. 14 is a schematic diagram of a structure of a rotation mechanism formed by assembling the structures shown in FIG. 12 and FIG. 13 in a closed state; and
FIG. 15 is a schematic diagram of a structure of the rotation mechanism shown in FIG. 14 in an unfolded state.

### Description of reference numerals:

100 and 1: rotation mechanism; 2: body; 50: first frame; 60: second frame; 3: foldable display screen; 4: outer screen;
110 and 10: primary swing arm; 120 and 20: sliding groove bracket; 130 and 30: shaft cover; 121 and 40: stop portion;
111 and 11: sliding portion; 112 and 12: protruding portion; 13: recessed portion; 14: accommodating groove; 15: avoidance hole; 122 and 21: sliding groove; 22: slideway; 221: slideway inner bottom wall; 222: opening end; 223: slideway end wall; 23: raised portion; 231: first protrusion; 232: second protrusion; 123: upper bracket; 124: lower bracket; 41: first end surface; 42: second end surface; 70: secondary swing arm.

### DESCRIPTION OF EMBODIMENTS

Technical solutions in embodiments of this application are described below with reference to the accompanying drawings in embodiments of this application.

Terms used in the following embodiments are only intended to describe particular embodiments, but are not intended to limit this application. As used in this specification and the appended claims of this application, singular expressions form, "one", "a", "said", "foregoing", "the", and "this" are intended to include expressions such as "one or more", unless otherwise clearly indicated in the context. It should be further understood that, in the following embodiments of this application, "at least one" and "one or more" mean one, two, or more than two. A term "and/or" is used to describe an association relationship between associated objects and represents that three relationships may exist. For example, A and/or B may represent: only A exists, both A and B exist, and only B exists, where A and B may be singular or plural. The character "/" generally indicates an "or" relationship between the associated objects.

Reference to "one embodiment", "some embodiments", or the like described in this specification means that one or more embodiments of this application include a specific feature, structure, or characteristic described with reference to the embodiments. Therefore, statements, for example, "in one embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "comprise", "have", and variations thereof all mean "including but not limited to", unless otherwise specified.

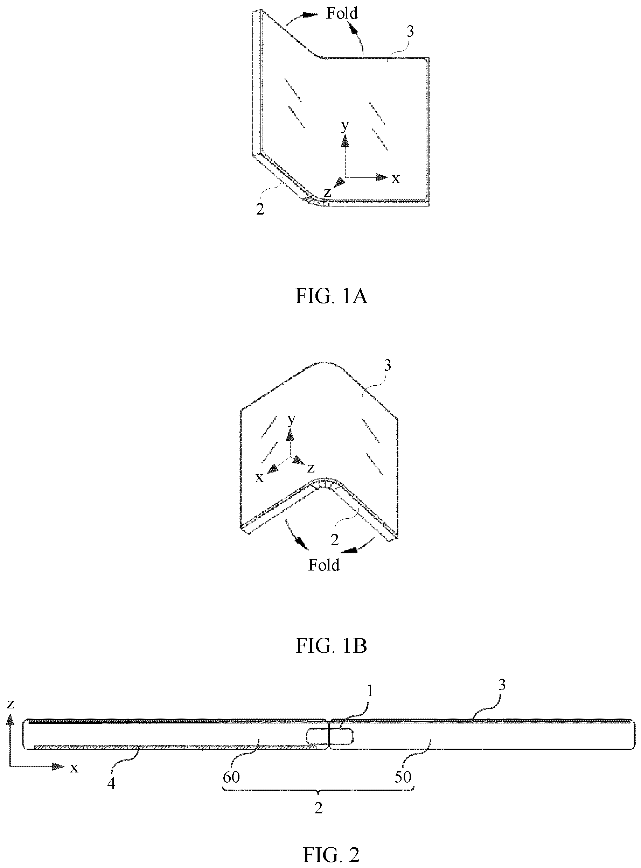

FIG. 1A is a schematic diagram of a form of a mobile phone with an inward foldable screen, and FIG. 1B is a schematic diagram of a form of a mobile phone with an outward foldable screen. Refer to FIG. 1A and FIG. 1B. An embodiment of this application provides a foldable electronic device.

It should be noted that, the electronic device according to this embodiment of this application may include, but is not limited to, a mobile or stationary terminal with a foldable function such as a mobile phone, a tablet computer, a notebook computer, an ultra-mobile personal computer (ultra-mobile personal computer, UMPC), a handheld computer, a touch screen TV, a walkie-talkie, a netbook, a POS terminal, a personal digital assistant (personal digital assistant, PDA), a wearable device, or a virtual reality device. This is not limited herein.

The following uses a foldable screen mobile phone as an example for specific description.

Refer to FIG. 1A and FIG. 1B. A width direction of the foldable screen mobile phone may be defined as an x direction, a height direction of the mobile phone may be defined as a y direction, and a thickness direction of the mobile phone may be defined as a z direction. FIG. 1 shows a mobile phone in a form in which a size in the x direction is smaller than a size in the y direction. The mobile phone in a form in which a size in the x direction is greater than a size in the y direction is not separately shown in FIG. 1. Refer to FIG. 1A and FIG. 1B. A conventional foldable screen mobile phone may include a mobile phone with an inward foldable screen, a mobile phone with an outward foldable screen based on different bending directions of the conventional foldable screen mobile phone. The mobile phone with an inward foldable screen is shown in FIG. 1A, and the mobile phone with an outward foldable screen is shown in FIG. 1B.

Refer to FIG. 1A. A body 2 of the mobile phone with an inward foldable screen can be folded to one side of a foldable display screen 3, and the foldable display screen 3 is hidden on an inner side of the body 2 after the body 2 is folded, so that the foldable display screen 3 is hidden in a folded state of the body 2 and a normal straight screen is presented in an unfolded state of the body 2. A body 2 of the mobile phone with an outward foldable screen can be folded to a back side of a foldable display screen 3, and the foldable display screen 3 surrounds the body 2 after the body 2 is folded, so that the foldable display screen 3 surrounds the body 2 in a folded state of the body 2 to form a surrounding screen, and a normal straight screen is presented in an unfolded state of the body 2.

FIG. 2 is a schematic diagram of a structure of a mobile phone with an inward foldable screen in an unfolded state. FIG. 2 is a schematic diagram of a mobile phone with an inward foldable screen in an unfolded state in an xz plane. The mobile phone with an inward foldable screen may include: a body 2 and a foldable display screen 3, and the foldable display screen 3 is attached to one surface of the body 2. For a mobile phone with an inward foldable screen that can be folded once, a body 2 of the mobile phone may include a first frame 50 and a second frame 60, and the first frame 50 and the second frame 60 are respectively disposed on two sides of a rotation mechanism 1. When a user applies force to the body 2 to rotate the first frame 50 and the second frame 60, the first frame 50 and the second frame 60 may be rotated around the rotation mechanism 1, to implement unfolding and folding. An outer screen 4 is further attached to another surface of one frame (for example, the second frame 60) in the body 2, so that after the foldable display screen 3 is hidden in a folded state of the body 2, the mobile phone with an inward foldable screen can still achieve a normal straight screen effect through the outer screen 4.

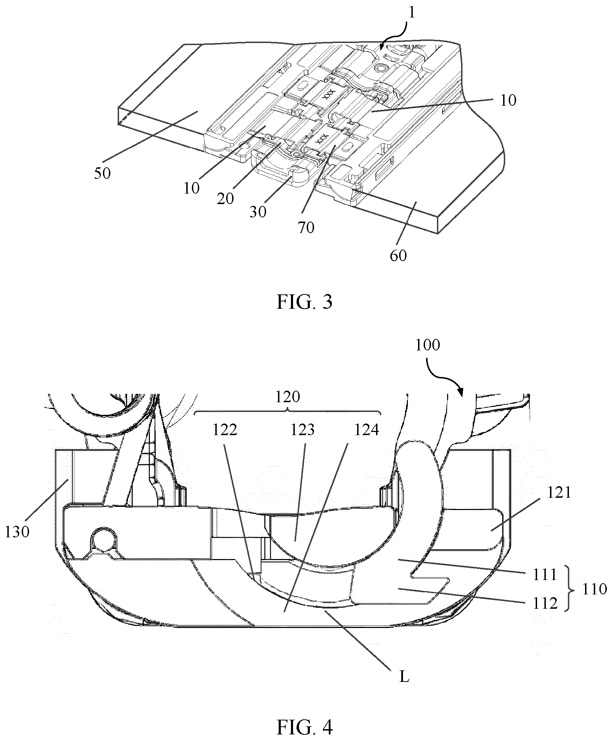

FIG. 3 is a schematic diagram of a complete structure of a rotation mechanism. As shown in FIG. 3, the rotation mechanism 1 may include a shaft cover 30, and a sliding groove bracket 20 and a primary swing arm 10 that are disposed on the shaft cover 30. In addition, the rotation mechanism 1 further includes a secondary swing arm 70, and the secondary swing arm 70 is configured to control a closed form of a foldable display screen of an electronic device. The secondary swing arm 70 in FIG. 3 is marked with xxx for more clearly distinguishing the secondary swing arm 70 from the primary swing arm 10. A first frame 50 and a second frame 60 that can rotate around the rotation mechanism 1 are further connected to two sides of the rotation mechanism 1. A sliding groove formed by the sliding groove bracket 20 is slidably connected to sliding portions on two sides of one end of the corresponding primary swing arm 10, and the other end of the primary swing arm 10 is connected to the first frame 50 (or the second frame 60) on a corresponding side via a connecting block. The primary swing arm 10 connected to the first frame 50 and the second frame 60 may slide back and forth in a corresponding sliding groove to implement opening and closing of a body. To prevent the primary swing arm 10 from being disengaged from the sliding groove in a closing process, an anti-disengagement structure is usually required to be disposed on the rotation mechanism 1. It should be noted that, there may be a plurality of primary swing arms 10 and secondary swing arms 70, and the primary swing arms 10 and the secondary swing arms 70 are arranged according to a preset rule. For example, the primary swing arms 10 and the secondary swing arms 70 are alternately arranged on one side of the rotation mechanism 1 in a y direction of the electronic device, and the primary swing arms 10 and the secondary swing arms 70 are oppositely arranged in an x direction parallel to the electronic device. A specific arrangement manner of the primary swing arms 10 and the secondary swing arms 70 is not limited in this embodiment of this application. Only a single primary swing arm 10 is used as an example for specific description in the following.

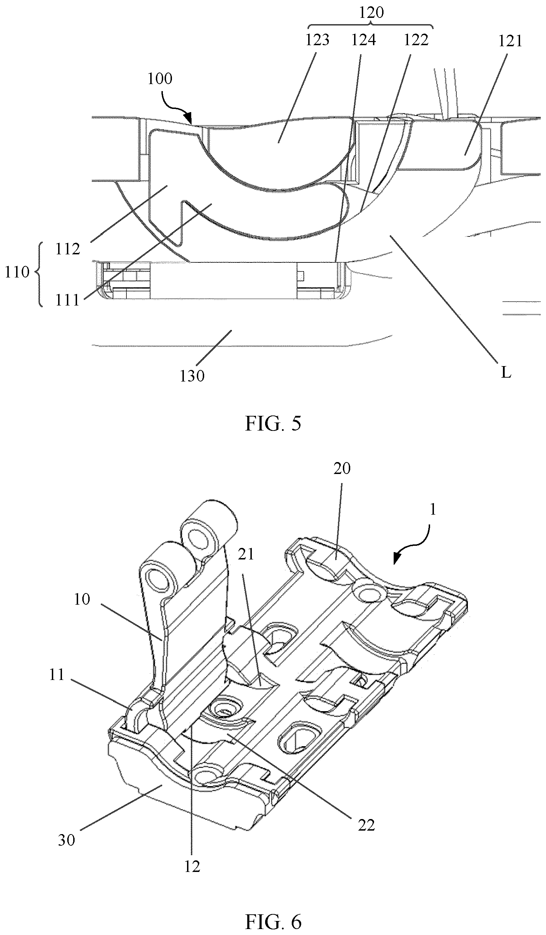

FIG. 4 is a schematic diagram of a primary swing arm at a closed position in a conventional rotation mechanism. FIG. 5 is a schematic diagram of a primary swing arm at an unfolded position in a conventional rotation mechanism. As shown in FIG. 4 and FIG. 5, a rotation mechanism 100 in a related technology includes a protruding portion 112 disposed on a sliding portion 111 of a primary swing arm 110. The protruding portion 112 can slide along a limiting groove L in a sliding groove bracket 120 to a stop portion 121 disposed on the sliding groove bracket 120 when the primary swing arm 110 is closed, to limit sliding of the primary swing arm 110.

Refer to FIG. 4 and FIG. 5. The conventional protruding portion 112 is disposed on one side of the sliding portion 111 facing away from a front surface of the sliding groove bracket 120, so that the protruding portion 112 and the sliding portion 111 form a bent structure facing an inner wall of a sliding groove 122. It may be understood that, the limiting groove L is formed on the inner wall of the sliding groove 122 and extends horizontally inward. In this way, for ease of assembly in such an anti-disengagement structure, generally, the sliding groove bracket 120 is of a disassembled structure, and mainly includes an upper bracket 123 and a lower bracket 124. The upper bracket 123 and the lower bracket 124 are configured to form the sliding groove 122 adapted to the sliding portion 111.

During assembly of the rotation mechanism 100, the lower bracket 124 may be first mounted on a shaft cover 130, and then the primary swing arm 110 is mounted on the lower bracket 124. Specifically, the sliding portion 111 is embedded into the sliding groove 122, the protruding portion 112 is inserted into the limiting groove L, and finally, the upper bracket 123 is correspondingly soldered to a preset position of the lower bracket 124, to form the sliding groove 122 adapted to the primary swing arm 110.

However, because the sliding groove bracket 120 is of a disassembled structure with a large quantity of parts, an overall fit tolerance chain is long. In addition, because there is a tolerance in a soldering process, after the upper bracket 123 is correspondingly soldered at the preset position of the lower bracket 124, a position of the upper bracket 123 relative to the position of the lower bracket 124 may exist a certain offset, resulting in an increase in a width of the sliding groove 122, so that a fit clearance between the sliding portion 111 of the primary swing arm 110 and the sliding groove 122 is increased, the primary swing arm 110 is easy to shake during sliding, and user experience is affected.

An embodiment of this application provides a rotation mechanism and a foldable electronic device. A sliding groove bracket is designed as an integral structure, so that a quantity of parts can be reduced, and a case in which a width of a sliding groove is increased due to an assembly problem can also be avoided. In addition, a primary swing arm that has a protruding portion on a first end surface and that is adapted to the sliding groove bracket of the integral structure is further correspondingly provided, so that the primary swing arm having the protruding portion can be ensured to be disposed in the sliding groove bracket of the integral structure, and the protruding portion is fitted with a stop portion disposed on a shaft cover or the sliding groove bracket, to prevent the primary swing arm from being disengaged.

The solutions provided in this application are described below with reference to the accompanying drawings by using the embodiments.

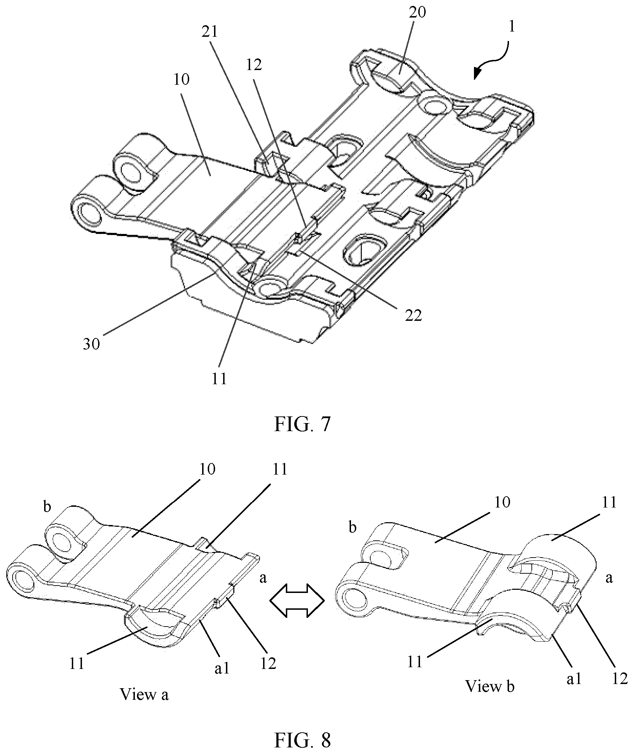

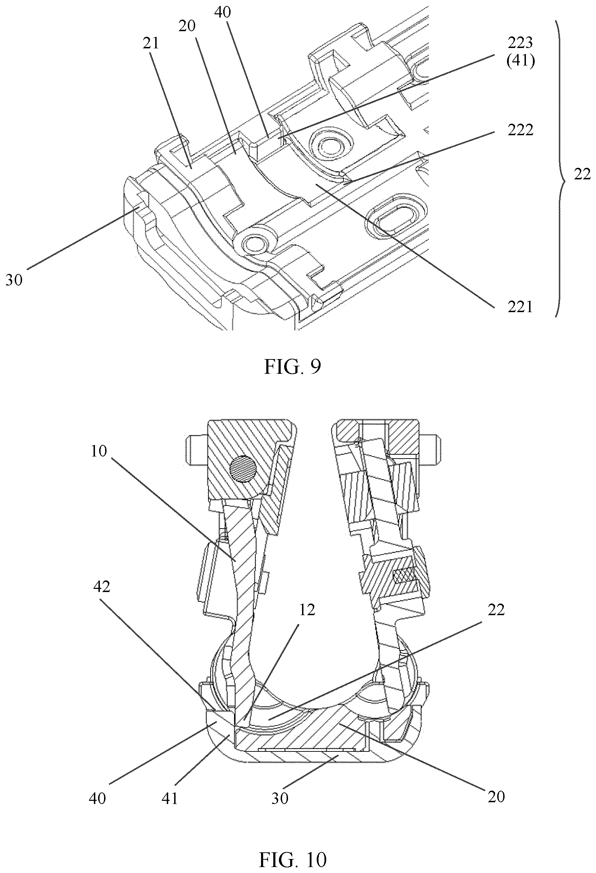

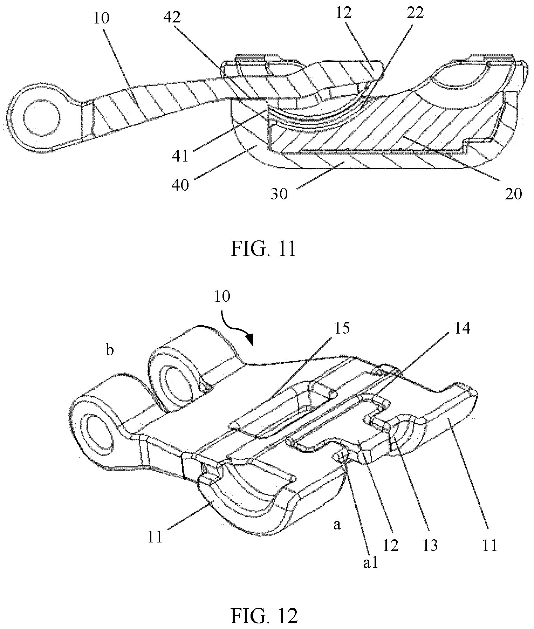

FIG. 6 is a schematic diagram of a structure of a rotation mechanism when a primary swing arm is at a closed position according to an embodiment of this application. FIG. 7 is a schematic diagram of a structure of a rotation mechanism when a primary swing arm is at an unfolded position according to an embodiment of this application. FIG. 8 is a schematic diagram of a structure of a primary swing arm according to an embodiment of this application. View a is a diagram of a structure of a primary swing arm 10 at one angle, and view b is a diagram of a structure of the primary swing arm 10 at another angle. FIG. 9 is a schematic diagram of a structure of a sliding groove bracket and a stop portion according to an embodiment of this application. FIG. 10 is a schematic diagram of a cross-section of a rotation mechanism formed by assembling the structures shown in FIG. 8 and FIG. 9 in a closed state. FIG. 11 is a schematic diagram of a cross-section of the rotation mechanism shown in FIG. 10 in an unfolded state. Refer to FIG. 6 to FIG. 11. A rotation mechanism 1 provided in embodiments of this application includes a primary swing arm 10, a sliding groove bracket 20, and a shaft cover 30. The primary swing arm 10 includes a first end a and a second end b that are oppositely arranged in a length direction, and the second end b is configured to be connected to a frame (for example, a first frame 50 or a second frame 60) of an electronic device. The primary swing arm 10 includes a sliding portion 11 and a protruding portion 12. The protruding portion 12 is disposed on a first end surface a1 of the two ends of the primary swing arm 10 that are oppositely arranged in the length direction, and the sliding portion 11 is disposed on a side surface opposite to the primary swing arm 10 in a width direction.

The sliding groove bracket 20 has a sliding groove 21 adapted to the sliding portion 11 and a slideway 22 configured to accommodate the protruding portion 12. The slideway 22 is an arc-shaped groove. When the sliding portion 11 slides back and forth in the sliding groove 21, the protruding portion 12 slides along the slideway 22, and the sliding groove bracket 20 is of an integral structure. The shaft cover 30 is located on one side of the sliding groove bracket 20 facing away from the primary swing arm 10. One of the shaft cover 30 and the sliding groove bracket 20 is provided with a stop portion 40 (referring to FIG. 9 to FIG. 11). The stop portion 40 protrudes from an inner surface of the shaft cover 30 facing the sliding groove bracket 20, and is located at one end of the slideway 22 close to an edge of the sliding groove bracket 20. When the primary swing arm 10 rotates from an unfolded position to a closed position, the protruding portion 12 is fitted with the stop portion 40, to prevent the primary swing arm 10 from being disengaged from one end of the sliding groove 21 close to the edge of the sliding groove bracket 20.

In an implementation, refer to FIG. 9. One side of the stop portion 40 provided in this embodiment of this application facing the slideway 22 has a first end surface 41. When the primary swing arm 10 rotates from the unfolded position to the closed position, the protruding portion 12 abuts against the first end surface 41. In this way, the protruding portion 12 and the stop portion 40 are not easy to slide or offset at an abutted position, and the abutment is more stable and firm.

Refer to FIG. 8. In an implementation, the primary swing arm 10 includes two sliding portions 11, and the two sliding portions 11 are respectively disposed on two opposite sides of the first end a in the width direction. The protruding portion 12 may be disposed at a central position of the first end a of the primary swing arm 10. In this way, a structure of the primary swing arm 10 may be more symmetrical, so that force is more evenly distributed during rotation, thereby facilitating improvement of hand feel of a user. In another implementation, a recessed portion may be formed in a direction in which the first end surface a1 of the primary swing arm 10 faces the second end b, the protruding portion 12 may be disposed at a central position of the recessed portion, and one end of the protruding portion 12 extends out of a surface of the recessed portion. Alternatively, the protruding portion 12 may not be disposed at the central position of the first end a. A specific position of the protruding portion 12 on the first end surface a1 is not limited in this embodiment of this application.

In an implementation, as shown in FIG. 8, the protruding portion 12 may be integrally formed and disposed on the first end surface a1 of the primary swing arm 10. In this way, the protruding portion 12 is integrally formed with the primary swing arm 10. This is easy for processing and not easy to be disengaged, and reliability of the structure is high. In another implementation, the protruding portion 12 may alternatively be soldered or may be detachably connected to the primary swing arm 10. This is not specifically limited in this embodiment of this application.

Refer to FIG. 9. The sliding groove bracket 20 and the stop portion 40 shown in FIG. 9 may be adapted to the primary swing arm 10 shown in FIG. 8. In an implementation, the slideway 22 may be disposed on a side surface of the sliding groove bracket 20 facing the primary swing arm 10. Specifically, the side surface of the sliding groove bracket 20 facing the primary swing arm 10 is recessed inward to form the slideway 22. The slideway 22 may include a slideway inner bottom wall 221, an opening end 222 and a slideway end wall 223 that are oppositely arranged in a sliding direction of the protruding portion. The slideway inner bottom wall 221 is located between the opening end 222 and the slideway end wall 223. The protruding portion is configured to move along the slideway inner bottom wall 221 when the sliding portion slides back and forth along the sliding groove 21. The slideway end wall 223 is configured as the first end surface 41 of the stop portion 40. When the primary swing arm 10 rotates from the unfolded position to the closed position, the protruding portion 12 enters the slideway 22 through the opening end 222, and when the primary swing arm 10 rotates to the closed position, the protruding portion 12 abuts against the slideway end wall 223. In this way, the slideway 22 can be better adapted to a moving track of the protruding portion 12, and the protruding portion 12 is stopped at the slideway end wall 223. This is simple and effective in structure and is easy for processing.

In an implementation, as shown in FIG. 9, the stop portion 40 may be disposed on the shaft cover 30. In this way, only after the shaft cover 30 is assembled with the sliding groove bracket 20, the stop portion 40 is fitted with the protruding portion 12 of the primary swing arm 10 and performs a function of preventing disengagement. The primary swing arm 10 and the sliding groove bracket 20 may be first assembled, and then are integrally assembled on the shaft cover 30. The overall structure is skillful, easy for processing and of low costs, and it is convenient to assemble the primary swing arm 10 with the protruding portion 12. It should be noted that, in this implementation, because the stop portion 40 is disposed on the shaft cover 30, and both the stop portion 40 and the sliding groove bracket 20 are separate parts, the slideway end wall 223 of the slideway 22 on the sliding groove bracket 20 is served by the first end surface 41 of the stop portion 40. In other words, when the shaft cover 30 is not assembled with the sliding groove bracket 20, the opening end 222 and the slideway inner bottom wall 221 of the slideway 22 are separated from the slideway end wall 223.

In addition, when the recessed portion is formed in a direction in which the first end surface a1 of the primary swing arm 10 faces the second end b, the protruding portion 12 is disposed on the recessed portion, and one end of the protruding portion 12 extends out of the surface of the recessed portion, the sliding groove bracket and the stop portion shown in FIG. 9 may also be adapted to each other, and the stop portion 40 disposed on the shaft cover 30 is fitted with the protruding portion 12 to perform anti-disengagement and stopping. It should be noted that, through disposed positions of the protruding portion 12 and the stop portion 40 provided in this embodiment of this application, a person skilled in the art may make adaptive structural adjustments to the slideway 22 on the sliding groove bracket 20 with reference to a specific situation and requirement, and a specific structure should also fall within the protection scope of embodiments of this application.

Refer to FIG. 10 and FIG. 11. One side of the stop portion 40 facing the slideway 22 has the first end surface 41. When the primary swing arm 10 rotates from the unfolded position to the closed position, the protruding portion 12 abuts against the first end surface 41. The stop portion 40 further includes a second end surface 42 connected to the first end surface 41. When the primary swing arm 10 rotates to the unfolded position, a first side surface of the primary swing arm 10 facing the shaft cover 30 abuts against the second end surface 42. In this way, after the primary swing arm 10 rotates from the closed position to the unfolded position, the second end surface 42 of the stop portion 40 may further perform a limiting function on the primary swing arm 10, to prevent the primary swing arm 10 from rotating excessively and damaging other parts. In an implementation, the second end surface 42 of the stop portion 40 may be perpendicular to the first end surface 41 of the stop portion 40. In this way, the primary swing arm 10 may be rotated 90 degrees between the closed position and the unfolded position. This better meets actual use requirements and experience of the user. In another implementation, an included angle greater than 90 degrees may be formed between the second end surface 42 and the first end surface 41, where an opening direction of the included angle faces a bottom surface of the shaft cover 30. Specifically, adjustments may be made based on a situation and experience. This is not specifically limited in embodiments of this application.

In an implementation, an assembly sequence of the rotation mechanism shown in FIG. 10 and FIG. 11 is as follows. The primary swing arm 10 is first mounted on the sliding groove bracket 20, and then the sliding groove bracket 20 and the primary swing arm 10 are integrally mounted on the shaft cover 30. When the primary swing arm 10 is mounted, the sliding portion 11 of the primary swing arm 10 may be aligned with an entrance of the sliding groove 21, and after the protruding portion 12 is aligned with the slideway 22, the sliding portion 11 and the protruding portion 12 correspondingly slide into the sliding groove 21 and the slideway 22 to complete the mounting. After the sliding groove bracket 20 and the primary swing arm 10 are integrally mounted on the shaft cover 30, the stop portion 40 is fitted with the protruding portion 12, to prevent the sliding portion 11 of the primary swing arm 10 from being disengaged from the sliding groove 21. In this way, the sliding groove bracket 20 provided in embodiments of this application is designed as an integral structure and is provided with the slideway 22 adapted to the protruding portion 12, the protruding portion 12 is disposed on the first end surface a1 of the two opposite ends of the primary swing arm 10 in the length manner, and the stop portion 40 is disposed on the shaft cover 30. Through an adaptive design of the protruding portion 12, the primary swing arm 10 provided with the protruding portion 12 can be ensured to be disposed in the sliding groove bracket 20 of the integral structure, so that the protruding portion 12 is fitted with the stop portion 40 after the primary swing arm 10 is closed. In this way, a total quantity of parts of the rotation mechanism is small. This is convenient to assembly, and a case in which a width of the sliding groove 21 formed on the sliding groove bracket 20 is increased due to an assembly problem can also be avoided, so that a fit clearance between the sliding groove 21 and the primary swing arm 10 is moderate, the primary swing arm 10 is not easy to shake during sliding, and user experience is improved.

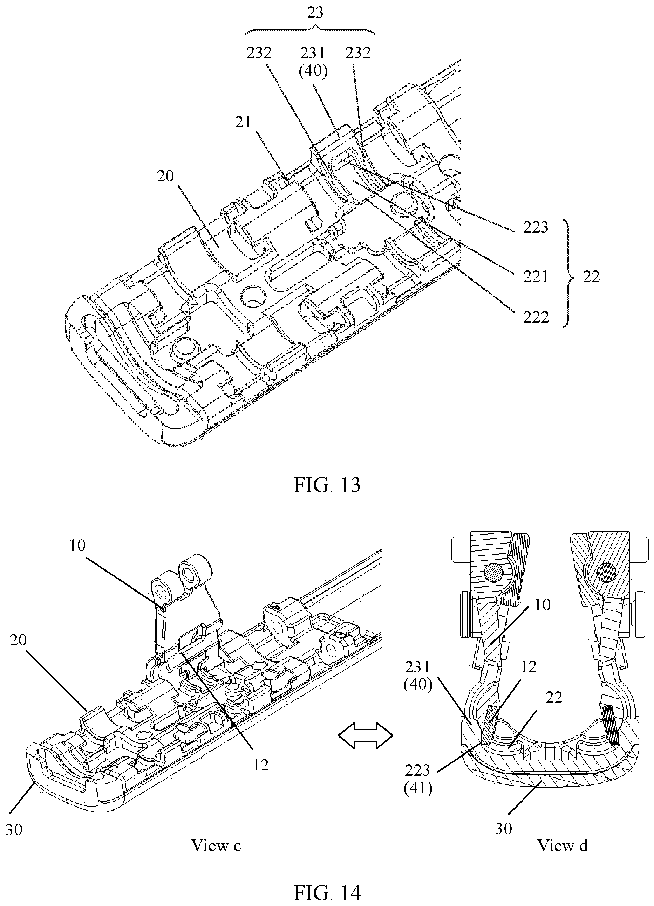

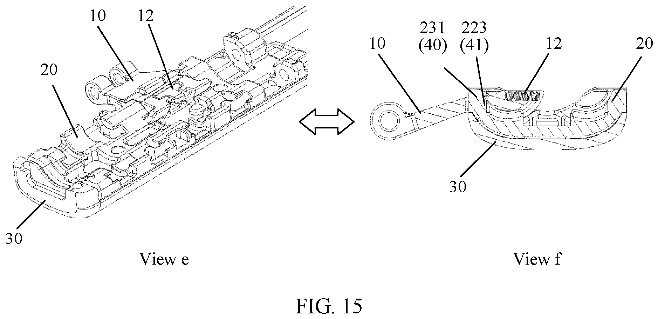

FIG. 12 is a schematic diagram of a structure of another primary swing arm according to an embodiment of this application. FIG. 13 is a schematic diagram of a structure of another sliding groove bracket and another stop portion according to an embodiment of this application. FIG. 14 is a schematic diagram of a structure of a rotation mechanism formed by assembling the structures shown in FIG. 12 and FIG. 13 in a closed state. View c is a diagram of a three-dimensional structure of the rotation mechanism in the closed state, and view d is a diagram of a cross-sectional structure of the rotation mechanism in the closed state. FIG. 15 is a schematic diagram of a structure of the rotation mechanism shown in FIG. 14 in an unfolded state. View e is a diagram of a three-dimensional structure of the rotation mechanism in the unfolded state, and view f is a diagram of a cross-sectional structure of the rotation mechanism in the unfolded state. Refer to FIG. 12 to FIG. 15. In another implementation, a primary swing arm 10 includes two sliding portions 11, and the two sliding portions 11 are respectively disposed on two opposite sides of a first end a in a width direction. A recessed portion 13 is formed in a direction in which a first end surface a1 of the primary swing arm 10 faces a second end b. An accommodating groove 14 is further provided at one end of the recessed portion 13 close to the second end b, and the accommodating groove 14 communicates with the recessed portion 13. A protruding portion 12 is embedded in the accommodating groove 14, and one end of the protruding portion 12 extends out of a surface of the recessed portion 13. In this way, the protruding portion 12 is detachably connected to the primary swing arm 10, so that an assembly manner among the primary swing arm 10, a sliding groove bracket 20, and a shaft cover 30 can be more flexible, and can also be better adapted to the sliding groove bracket 20 of an integral structure. In an implementation, the accommodating groove 14 may be provided at a central position of one end of the recessed portion 13 close to the second end b. The accommodating groove 14 may be a T-shaped groove. Accordingly, the protruding portion 12 may be a T-shaped block, and a longitudinal side of the T-shaped block extends out of the surface of the recessed portion 13. In another implementation, the accommodating groove 14 may alternatively be a straight-line-shaped groove or in another shape. This is not specifically limited in this embodiment of this application. The protruding portion 12 may be soldered in the accommodating groove 14, or may be embedded in the accommodating groove 14 in another manner. This is not limited in this embodiment of this application.

Refer to FIG. 13. The sliding groove bracket 20 and a stop portion 40 shown in FIG. 13 may be adapted to the primary swing arm 10 shown in FIG. 12. In an implementation, a raised portion 23 is formed on a side surface of the sliding groove bracket 20 facing the primary swing arm 10, and the raised portion 23 is recessed inward to form a slideway 22. The slideway 22 may include a slideway inner bottom wall 221, an opening end 222 and a slideway end wall 223 that are oppositely arranged in a sliding direction of the protruding portion 12. The slideway inner bottom wall 221 is located between the opening end 222 and the slideway end wall 223. The protruding portion 12 is configured to move along the slideway inner bottom wall 221 when the sliding portions 11 slide back and forth along the sliding groove 21. The slideway 22 separates the raised portion 23 into a first protrusion 231 and two second protrusions 232. The two second protrusions 232 are oppositely arranged on two sides of the first protrusion 231, and the first protrusion 231 and the two second protrusions 232 jointly define the slideway 22. The first protrusion 231 is configured as the stop portion 40, and one side of the first protrusion 231 facing the slideway 22 is the slideway end wall 223. Adapted to the sliding groove bracket 20 in FIG. 13, the recessed portion 13 on the primary swing arm 10 shown in FIG. 12 is configured to avoid the second protrusions 232 when the protruding portion 12 slides into the slideway 22. In addition, an avoidance hole 15 is further formed on the primary swing arm 10, and the first protrusion 231 is configured to pass through the avoidance hole 15 when the primary swing arm 10 is at an unfolded position. A size and a shape of the avoidance hole 15 may be determined based on a size and a shape of the first protrusion 231. This is not specifically limited in this embodiment of this application. In this way, the stop portion 40 is disposed on the sliding groove bracket 20. This facilitates standard processing of the shaft cover 30. In addition, arc surfaces of the second protrusions 232 may be set to be long and adapted to a rotation track of a bottom surface of the recessed portion 13 of the primary swing arm 10, so that a sliding fit area between the primary swing arm 10 and the sliding groove bracket 20 is increased when the primary swing arm 10 rotates, smoother rotation of the primary swing arm 10 is enables, and better user experience is provided.

Refer to FIG. 14 and FIG. 15. The first protrusion 231 is configured as the stop portion 40. One side of the first protrusion 231 facing the slideway 22 is the slideway end wall 223, that is, equivalent to the first end surface 41 of the stop portion 40. When the primary swing arm 10 rotates from the unfolded position to the closed position, the protruding portion 12 abuts against the first end surface 41. When the primary swing arm 10 rotates to the unfolded position, a first side surface of the primary swing arm 10 facing the shaft cover 30 abuts against a top surface of the shaft cover 30 facing away from the edge of the sliding groove bracket 20. In this way, even if the first protrusion 231 is disposed, the unfolded position of the primary swing arm 10 is not limited.

In an implementation, an assembly sequence of the rotation mechanism shown in FIG. 14 and FIG. 15 is as follows. The sliding groove bracket 20 is first mounted on the shaft cover 30, a primary swing arm 10 without the protruding portion 12 is then mounted on the sliding groove bracket 20, and after the sliding portion 11 of the primary swing arm 10 correspondingly slides into the sliding groove 21, the protruding portion 12 is finally embedded in the accommodating groove 14, to complete the mounting. After the mounting is completed, the protruding portion 12 abuts against an end surface (that is, the slideway end wall 223) of the first protrusion 231 facing the sliding groove 21, to prevent the sliding portions 11 of the primary swing arm 10 from being disengaged from the sliding groove 21. In this way, the sliding groove bracket 20 provided in embodiments of this application is designed as an integral structure, and is further provided with the raised portion 23, the raised portion 23 is recessed inward to form the slideway 22 adapted to the protruding portion 12, so that a sliding fit area between the primary swing arm 10 and the sliding groove bracket 20 is increased when the primary swing arm 10 rotates, smoother rotation of the primary swing arm 10 is enabled, and better user experience is provided. In addition, the protruding portion 12 is detachably disposed in the accommodating groove 14 of the recessed portion 13 of the primary swing arm 10, and the first protrusion 231 is configured as the stop portion 40. Through an adaptive design of the detachable protruding portion 12, the primary swing arm 10 provided with the protruding portion 12 can be ensured to be disposed in the sliding groove bracket 20 of the integral structure provided with the raised portion 23, so that the protruding portion 12 is fitted with the stop portion 40 after the primary swing arm 10 is closed. The entire structure of the rotation mechanism is skillful and easy to be assembled, and has strong practicability.

In this way, according to the rotation mechanism provided in embodiments of this application, the protruding portion is disposed on the first end surface of the two opposite ends of the primary swing arm in the length manner, the stop portion is disposed on one of the shaft cover and the sliding groove bracket, and the sliding groove bracket is of an integral structure and is provided with a slideway adapted to the protruding portion. The primary swing arm provided with the protruding portion can be ensured to be disposed in the sliding groove bracket of the integral structure, so that the protruding portion is fitted with the stop portion after the primary swing arm is closed, and it is ensured that the primary swing arm is not disengaged from an assembly structure of the sliding groove bracket and the shaft cover. In addition, a total quantity of parts is small. This is convenient to assembly, and a case in which a width of the sliding groove formed on the sliding groove bracket is increased due to an assembly problem can also be avoided, so that a fit clearance between the sliding groove and the primary swing arm is moderate, the primary swing arm is not easy to shake during sliding, and user experience is improved.

In addition, according to the foldable electronic device provided in embodiments of this application, the sliding groove bracket of the rotation mechanism used is of an integral structure, the protruding portion is disposed on the first end surface of two opposite ends of the primary swing arm in the length manner, and the stop portion is disposed on one of the shaft cover and the sliding groove bracket. A total quantity of parts is small. This is convenient to assembly, and a case in which a width of the sliding groove formed on the sliding groove bracket is increased due to an assembly problem can also be avoided, so that a fit clearance between the sliding groove and the primary swing arm is moderate, the primary swing arm is not easy to shake during sliding, and user experience is improved.

It is easy to understand that a person skilled in the art may combine, split, and recombine embodiments of this application based on several embodiments provided in this application to obtain another embodiment, and all of the embodiments fall within the protection scope of this application.

The objectives, technical solutions, and beneficial effects of this application are further described in detail in the foregoing specific implementations. It should be understood that the foregoing descriptions are merely specific implementations of this application, but are not intended to limit the protection scope of this application. Any modification, equivalent substitution, improvement, and the like made based on the technical solutions in this application shall fall within the protection scope of this application.

## Claims

1. A rotation mechanism, comprising:
a primary swing arm (10), comprising a sliding portion (11) and a protruding portion (12), wherein the primary swing arm (10) comprises a first end and a second end that are oppositely arranged in a length direction, the second end is configured to be connected to a frame of an electronic device, the protruding portion (12) is disposed on a first end surface of the two ends of the primary swing arm (10) that are oppositely arranged in the length direction, and the sliding portion (11) is disposed on a side surface opposite to the primary swing arm (10) in a width direction;
a sliding groove bracket (20), having a sliding groove (21) adapted to the sliding portion (11) and a slideway (22) configured to accommodate the protruding portion (12), wherein the slideway (22) is an arc-shaped groove, when the sliding portion (11) slides back and forth in the sliding groove (21), the protruding portion (12) slides along the slideway (22), and the sliding groove bracket (20) is of an integral structure; and
a shaft cover (30), located on one side of the sliding groove bracket (20) facing away from the primary swing arm (10), wherein a stop portion (40) is disposed on one of the shaft cover (30) and the sliding groove bracket (20), the stop portion (40) protrudes from an inner surface of the shaft cover (30) facing the sliding groove bracket (20) and is located at one end of the slideway (22) close to an edge of the sliding groove bracket (20), and the protruding portion (12) is configured to be fitted with the stop portion (40) in a rotation process of the primary swing arm (10).

2. The rotation mechanism according to claim 1, wherein the stop portion (40) is configured to prevent the primary swing arm (10) from being disengaged or overextended from one end of the sliding groove (21) close to the edge of the sliding groove bracket (20).

3. The rotation mechanism according to claim 1, wherein one side of the stop portion (40) facing the slideway (22) has a first end surface (41), and the protruding portion (12) is configured to abut against the first end surface (41).

4. The rotation mechanism according to claim 3, wherein the slideway (22) comprises a slideway inner bottom wall (221), an opening end (222) and a slideway end wall (223) that are oppositely arranged in a sliding direction of the protruding portion (12), the slideway inner bottom wall (221) is located between the opening end (222) and the slideway end wall (223), and the protruding portion (12) is configured to move along the slideway inner bottom wall (221) when the sliding portion (11) slides back and forth along the sliding groove (21); and
the slideway end wall (223) is configured as the first end surface (41) of the stop portion (40), when the primary swing arm (10) rotates from an unfolded position to a closed position, the protruding portion (12) enters the slideway (22) through the opening end (222), and the protruding portion (12) is configured to abut against the slideway end wall (223).

5. The rotation mechanism according to claim 4, wherein the protruding portion (12) is integrally formed, or is disassembled to be disposed on the first end surface of the primary swing arm (10).

6. The rotation mechanism according to claim 4, wherein a recessed portion (13) is formed in a direction in which the first end surface of the primary swing arm (10) faces the second end, an accommodating groove (14) is further provided at one end of the recessed portion (13) close to the second end, and the accommodating groove (14) communicates with the recessed portion (13); and
the protruding portion (12) is embedded in the accommodating groove (14), and one end of the protruding portion (12) extends out of a surface of the recessed portion (13).

7. The rotation mechanism according to claim 5 or 6, wherein the stop portion (40) is disposed on the shaft cover (30).

8. The rotation mechanism according to claim 7, wherein the stop portion (40) further comprises a second end surface (42) connected to the first end surface (41), and when the primary swing arm (10) rotates to the unfolded position, a first side surface of the primary swing arm (10) facing the shaft cover (30) abuts against the second end surface (42).

9. The rotation mechanism according to claim 8, wherein the second end surface (42) of the stop portion (40) is perpendicular to the first end surface (41) of the stop portion (40).

10. The rotation mechanism according to claim 8, wherein an included angle between the second end surface (42) of the stop portion (40) and the first end surface (41) of the stop portion (40) is greater than 90 degrees, and an opening direction of the included angle faces a bottom surface of the shaft cover (30).

11. The rotation mechanism according to claim 5 or 6, wherein the slideway (22) is disposed on a side surface of the sliding groove bracket (20) facing the primary swing arm (10).

12. The rotation mechanism according to claim 5 or 6, wherein a raised portion (23) is formed on a side surface of the sliding groove bracket (20) facing the primary swing arm (10), the raised portion (23) is recessed inward to form the slideway (22), the slideway (22) separates the raised portion (23) into a first protrusion (231) and two second protrusions (232), the two second protrusions (232) are oppositely arranged on two sides of the first protrusion (231), and the first protrusion (231) and the two second protrusions (232) jointly define the slideway (22), wherein the first protrusion (231) is configured as the stop portion (40), and one side of the first protrusion (231) facing the slideway (22) is the slideway end wall (223); and
the recessed portion (13) on the primary swing arm (10) is configured to avoid the second protrusions (232) when the protruding portion (12) slides into the slideway (22), an avoidance hole (15) is further formed on the primary swing arm (10), and the first protrusion (231) is configured to pass through the avoidance hole (15) when the primary swing arm (10) is at the unfolded position.

13. The rotation mechanism according to claim 12, wherein when the primary swing arm (10) rotates to the unfolded position, a first side surface of the primary swing arm (10) facing the shaft cover (30) abuts against a top surface of the shaft cover (30) facing away from the edge of the sliding groove bracket (20).

14. The rotation mechanism according to any one of claims 1 to 6, wherein the protruding portion (12) is disposed at a central position of the first end of the primary swing arm (10); and
the primary swing arm (10) comprises two sliding portions (11), and the two sliding portions (11) are respectively disposed on two opposite sides of the first end in the width direction.

15. A foldable electronic device, comprising:
the rotation mechanism according to any one of claims 1 to 14; and
a first frame (50) and a second frame (60) that can rotate around the rotation mechanism, wherein the first frame (50) and the second frame (60) are separately connected to a second end of a primary swing arm (10) in the rotation mechanism.
